Europäisches Patentamt

European Patent Office

Office européen des brevets

(19)

⊙ Publication number: **0 285 248**

**A1**

(12) **EUROPEAN PATENT APPLICATION**

(21) Application number: **88301544.8**

(22) Date of filing: **23.02.88**

(51) Int. Cl.⁴ **H01L 29/28** , **B05D 1 36** , **C09K 19/00**

The title of the invention has been amended (Guidelines for Examination in the EPO, A-III, 7.3).

(30) Priority: **23.02.87 FI 870761**

(43) Date of publication of application: **05.10.88 Bulletin 88/40**

(84) Designated Contracting States: **AT BE CH DE ES FR GB GR IT LI LU NL SE**

(71) Applicant: **KSV-CHEMICALS OY Höyläämötie 11 SF-00380 Helsinki(FI)**

(72) Inventor: **Peltonen, Jouko Avaruuskatu 3 F 115 SF-02210 Espoo(FI)** Inventor: **Kinnunen, Paavo Punarinnantie 4 SF-02660 Espoo(FI)** Inventor: **Virtanen, Jorma Ristiaallokonkatu 4 C 71 SF-02320 Espoo(FI)**

(74) Representative: **Newell, William Joseph et al D. Young & Co., 10 Staple Inn London WC1V 7RD(GB)**

(54) **Film aggregate and a method for its preparation.**

(57) The film aggregate (A,B,C) comprises a conducting substrate on which there are at least three monomolecular layers prepared from a surface active organic compound of liquid crystal type using Langmuir-Blodgett film-forming techniques. The film layers form an uneven number, and make up at least three zones (A,B,C) which are parallel to the substrate surface, each zone comprising at least one monomolecular film layer. The or each film layer in alternate zones (A,C) including the zone nearest the substrate have been formed at a surface pressure which is lower than that used for making the film layers in the or each intermediate zone (B). The multi-layer films may be used in different applications in electronics.

FIG. 1b

EP 0 285 248 A1

## Film aggregate

This invention relates to a film aggregate which comprises at least three monomolecular layers provided on a conductive substrate and prepared from a surface active organic compound of liquid crystal type using Langmuir-Blodgett film-forming techniques.

The Langmuir-Blodgett technique for the preparation of monomolecular layers (monolayers) from surface active compounds of liquid crystal type, e.g. from phosphoglycerol and threitol derivatives substituted with long-chained, substantially aliphatic hydrocarbon side-chains, or from fatty acids or their derivatives, is known. In the general original publication by Irwin Langmuir (Langmuir. I. (1917) J. Am. Chem. Soc. 39, 1848) the principles are disclosed according to which the organisation of the compounds into a monomolecular surface film takes place. The monograph by George Gaines (Gaines. G.L.. Jr (1966) Insoluble Monolayers at Liquid-Gas Interfaces, Interscience Publishers. John Wiley and Sons Inc.. New York 1966) deals extensively with different methods for the preparation of and research relating to monomolecular surface films.

The Langmuir-Blodgett film-forming technique in short is based on letting a film-forming surface active compound orient itself at the interface between two different phases. for example, the interface between a liquid, such as water, glycerol etc, and a gas, such as air, argon etc. the hydrophilic part of the molecule orienting itself towards the liquid, and the hydrophobic part, i.e. the lipophilic part, orienting itself in a direction away from the liquid. A surface. active compound dissolved in a suitable organic solvent or a solvent mixture, for example in chloroform or cyclohexane, is spread onto the surface of a liquid contained in a trough. From the film spread as a monomolecular layer, for example onto a water surface. the solvent evaporates rapidly. By means of a boom which rests on top of the trough and which is in contact with the liquid surface, the available surface area of the liquid-gas-interface is restricted, the total area of the monomolecular surface film thus decreasing or increasing. By means of the boom it is thus possible to regulate the surface tension of the film, which is inversely proportional to the surface pressure of the film. and which is determined by measuring the force exerted on a sensor in the film by means of a sensitive balance. When a support forming the substrate is transported through the interface, preferably at constant speed, the film is deposited as a monomolecular layer onto the substrate, the lipophilic part towards the substrate when the support is transported through the interface in a direction from air to water. and the hydrophilic part towards the substrate when the support is transported through the film in the opposite direction. The thickness of the individual film layer is substantially dependant on the organic compound used for the preparation of the film and especially on the length of the aliphatic chains contained therein, and it is usually of the order of 20 to 30 Å.

By transporting the support several times through the interface, substantially any number of film layers may be deposited onto the substrate.

Electrical measurements made through Langmuir-Blodgett (LB) films, i.e. in a direction parallel with the normal of the film surface, show that the conductivity of the LB-films depends on the surface pressure used for making the films, and especially so that the conductivity of the film improves with increasing manufacturing surface pressure. Under an electric field the LB-film follows quantum mechanical laws. The LB-film thus acts as a potential barrier over which the electrons tunnel under the influence of the electric field. By changing the surface pressure used for making the film, the height of such a potential barrier may be regulated.

Potential barriers and interposed potential wells allowing electron resonance tunnelling have earlier been observed in heterostructures. The first resonance tunnelling observations were reported by Chang. Esaki and Tsu, Appl. Phys. Lett. 24, 12 (1974) p. 593, who studied GaAlAs/GaAs, GaAlAs heterostructures, wherein resonance manifested itself as tunnelling current maximums at voltages corresponding to the bound electronic states of the potential well. In the resonance state the energy of electrons corresponds to the bound state and the current reaches its maximum due to resonance tunnelling. When the voltage. that is the energy of the electrons increases further, the resonance state is passed and the current decreases. i.e. negative resistance is observed. - The prior known heterostructures have been manufactured using MBE-technique (molecular beam epitaxy) but they may also be prepared using metalorganic chemical vapor deposition. In the film aggregates thus made. negative resistance has generally been observed at low temperatures. At room temperature the phenomenon observed has mostly been very weak.

According to the Applicants' studies it has now been observed that electron resonance tunnelling takes place also in organic film aggregates, which have been made from surface active compounds of liquid crystal type utilizing Langmuir-Blodgett film-making technique Such films have. in comparison to the prior known heterostructures, the big advantage that in these resonance tunnelling phenomena can be observed clearly at room temperature, which is a major advantage when considering the use of the film aggregates. Specifically the Langmuir-Blodgett film-making techniques employed ensures that uniform film aggregates are obtained.

According to one aspect of this invention, there is provided a film aggregate which comprises at least three monomolecular layers provided on a conductive substrate and prepared from a surface active organic compound of liquid crystal type using techniques such as for example Langmuir-Blodgett film-forming techniques, wherein the film layers form an uneven number and make up at least three zones (A.B.C) which are parallel to the substrate surface, each zone (A,B,C) comprising at least one monomolecular film layer. the or each film layer in alternate zones (A,C) including the zone next to the substrate having been formed at a surface pressure which is lower than that used for making the film layers in the or each intermediate zone (B).

According to another aspect of this invention, there is provided a method for the preparation of a film aggregate comprising at least three monomolecular layers provided on a conductive substrate and prepared from a surface active organic compound of liquid crystal type using techniques such as for example Langmuir-Blodgett film-forming techniques, the film layers forming an odd number and making up at least three zones (A,B,C) parallel to the substrate surface each zone comprising at least one film layer wherein the or each film layer in alternate zones (A,C) including the zone to the substrate is made using a surface pressure which is lower than that used for making the films in the or each intermediate zone.

The film aggregate according to embodiments of the invention is thus characterized by a sandwich-type construction wherein on a conducting substrate serving as an electrode there are alternating zones containing one or several monomolecular film layers, and the zone next to the conducting substrate forming a potential barrier in the film aggregate is comprised of one or several film layers made at a low surface pressure, which zone is followed by a zone forming a potential well, which is comprised of one or several films made at a higher surface pressure as compared to the films in the first mentioned zone, which in turn is followed by a zone forming a potential barrier, etc. This alternation of zones may be continued so that the resultant film aggregate will contain several, preferably 2 or 3 potential wells, whereby the resonance phenomenon is increased even ten-fold. At the very top a second electrode may be placed.

Any material suitable for this purpose may be used as the conducting substrate serving as an electrode, for example a metal, such as copper, or an inert support material, such as glass, silicon quartz glass, plastic etc. which may be covered with a conducting layer forming one of the electrodes. A similar layer may also form the second electrode to be placed on top of the film aggregate, or such may be formed also by a Hg-drop.

In each film zone, viz. a zone forming a potential well or a potential barrier respectively, there is always at least one, preferably 2 to 7 film layers.

The properties of the film aggregate may be varied by varying its structure both on the level of the film zone structure as well as by varying the compound used for making the film. By changing the width of the zone forming a potential well, for example by using more film layers or by using a different surface active compound, the resonance voltage may be changed. A wide well (zone) gives the first resonance at a lower voltage than a narrower well and there is also a larger number of bound resonance states (denser). The height and the width of the potential barrier again affects resonance intensity, as naturally also the properties of the used surface active compound, such as characteristic resistance and film thickness. The height of the potential barrier also affects the number of bound states.

The absolute magnitude of the surface pressure used for making the film is not critical. but is naturally dependant on the film forming properties of the organic compound used in making the film, which properties are illustrated by the compression isotherm. Suitable surface pressures for making a film using the surface active compounds mentioned initially are in the range of 10 to 60 mN/m. advantageously 20 to 55 mN/m.

The zone(s) acting as the po tential well in the film aggregate are made using higher surface pressures than those acting as the potential barrier. The difference between the surface pressures is suitably in the range of about 15 to 35 mN/m in order to obtain usable results. The differences in surface pressure affects the number of bound states so that the larger the difference. the more bound states there exist.

The choice of organic compounds used for the preparation of the films is not critical provided they are surface active liquid crystal type compounds, which are suitable for the preparation of monomolecular layers using LB-technique. Typical for these compounds are, as mentioned earlier. a hydrophobic end part. and a hydrophilic end part. which is a basic requirement for their orientation as a monomolecular layer at the interface between the two phases. Typically such compounds are long-chained (8 to 40 C-atoms, especially 12 to 20 C-atoms) substantially aliphatic fatty acids. alcohols or amides. or derivatives thereof. Typical and good film forming properties are also exhibited by phosphoglycerol and threitol derivatives esterified, etherified or amidated by the said long-chained compounds.

The substantially aliphatic chains may contain other groups or, for example, hereto atoms as long as these do not affect the apolar nature of this group and thus render the preparation of the monomolecular layers more difficult and as long as they do not interfere with the electrical properties of the film.

The compounds usable in the film aggregate are partly known and if they are not commercially available, they may be manufactured using known methods. Such known methods may similarly be used for the preparation of new compounds for the purpose of the invention.

The invention will now be described by way of non-limiting example, reference being made to the accompanying drawings, in which:-

Figure 1 is a schematic illustration of an embodiment of a film aggregate according to the invention, wherein 1a shows a cross-section of film layers on top of a substrate, and 1b the same film aggregate, especially its energy and surface pressure levels, the number of film layers as well as the bound state;

Figure 2a shows another embodiment of aggregate having several potential wells and which corresponds to the aggregate according to the Example 1d below, and

Figure 2b shows the U-I-characteristics measured for the aggregate shown in the Figure 2a.

The film aggregate according to Figure 1a consists of a conducting substrate 1 of e.g. copper, onto which are deposited altogether nine film layers 2 of a surface active compound. The films of the first zone A have been made using a surface pressure of 25 mN/m forming one potential barrier in the film aggregate. The following three layers, which form a potential well B in the film aggregate, are made using a surface pressure of 40 mN/m. This is followed again by a zone C of three film layers formed using a surface pressure of 25 mN/m.

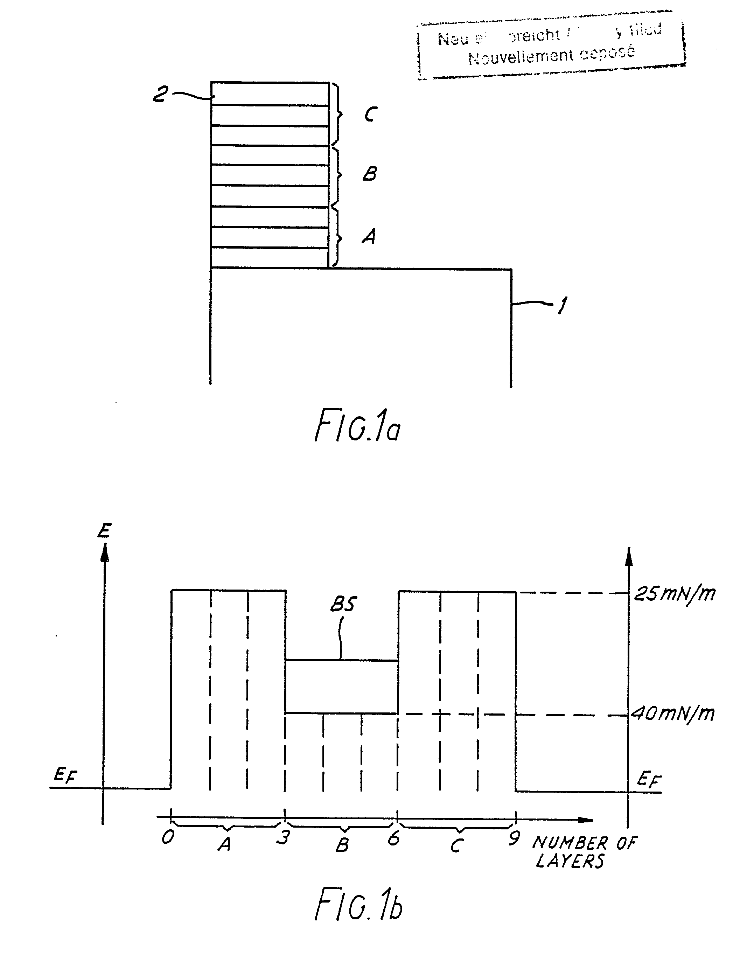

Figure 1b shows the same film aggregate, however, illustrating the potential levels associated with each zone of the film aggregate. BS means bound state, the existence of which gives rise to the resonance tunnelling phenomenon.

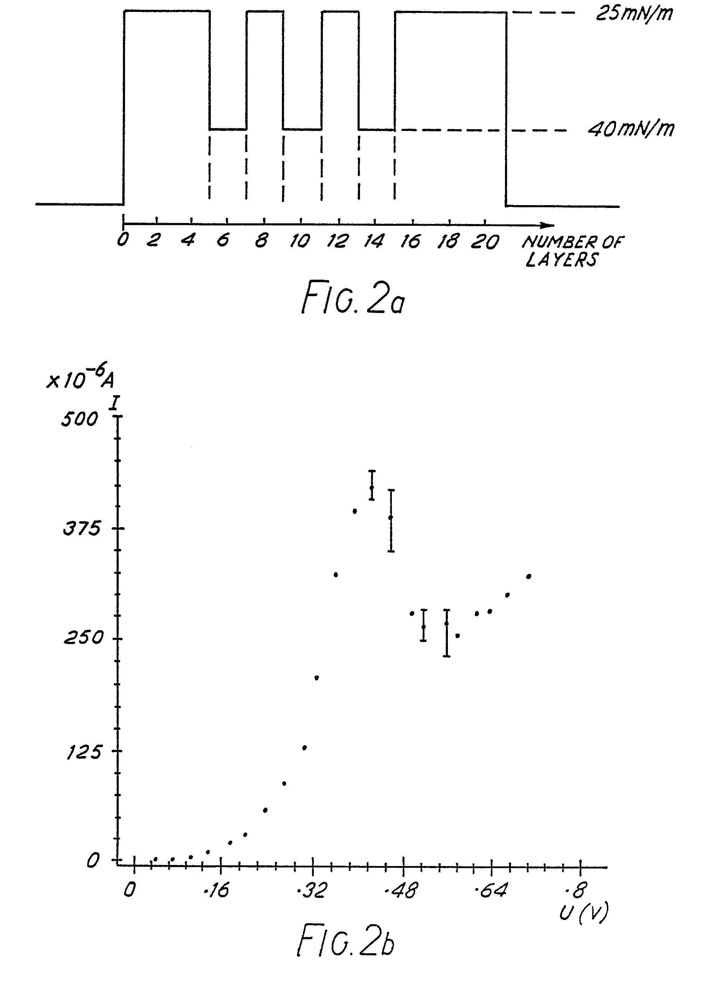

Figure 2a shows another embodiment of film aggregate with three potential wells each consisting of two film layers. As the outermost film zones forming potential barriers there are zones containing five and six film layers respectively. The film zones forming inner potential barriers con tain two film layers in each zone. The films of the potential barriers are made at a surface pressure of 25 mN/m and those of the potential wells at a surface pressure of 40 mN/m.

In the Figure 2b the U-I-characteristics for the aggregate of Figure 2a has been measured. According thereto the current initially increases normally as a function of voltage. The increase in current however gets stronger than normal and reaches a maximum, after which the current starts to fall temporarily. Resistance is then negative. The phenomenon is brought about by the afore mentioned bound state; when the energy imparted on the electrons by an outer electric field corresponds exactly to the energy of the bound state, resonance occurs and the current reaches a local maximum value.

Resonance tunnelling may be used for various applications in electronics. Due to the negative resistance, the U-I-characteristic of the aggregate has a step-wise shape, i.e. the number of states of the aggregate equals the number of resonances. This makes it possible to use the embodiments of film aggregate of the invention as a multistate memory. The same fact may also be applied for other logical circuits, for example in counters and dividers, as well as in transistors.

The following example illustrates the invention.

## Example

As film-forming substance arachidic acid $(CH_3(CH_2)_{18}COOH$ was used with a sub phase containing $1 \times 10^{-3}$ M $TbCl_2$. Arachidic acid was dissolved in chloroform at an amount of 1 mg ml$^{-1}$.

For the LB-film deposition, mechanically and electrolytically polished single crystal copper was used as the substrate. The advantage of this material is that it as a substrate simultaneously serves as the second electrode, the other electrode being a Hg-drop. Additionally formation of natural oxide is not as strong in copper as for example in aluminium. Adhesion of the LB-film to copper was as good as to quartz glass.

The deposition was carried out in a KSV-2200 type apparatus and it was begun 20 to 30 minutes after spreading a monolayer by moving the substrate upward through the layer at a rate of 5 mm min. Subsequent films were made by moving the substrate alternatingly upward and downward, the delay between the deposition of successive layers being about a minute. During deposition the chosen surface pressure was kept constant at the selected value using computer aided surface pressure monitoring back-coupled to the movement of the boom exerting pressure on the film. After deposition the multilayer films were dried in a vacuum desiccator. The current was measured in a box where laminar flow was maintained in order to create dustfree conditions. For the current measurements a Keithley 614 electrometer was used at room temperature. The contact area of the Hg-drop was approximately 1 mm².

Three film aggregates a to c were made, each having a single potential well, as well as a film aggregate d having three potential wells. The aggregates were:

| Structure | Number of film layers and surface pressure (mN/m) | | | | | | | |
|---|---|---|---|---|---|---|---|
| | a | | b | | c | | d | |
| 1. pot. barrier | 4 | 25 | 6 | 25 | 4 | 25 | 5 | 25 |
| 1. pot. well | 3 | 40 | 3 | 40 | 5 | 40 | 2 | 40 |
| 2. pot. barrier | 4 | 25 | 6 | 25 | 4 | 25 | 2 | 25 |
| 2. pot. well | - | | - | | - | | 2 | 40 |
| 3. pot. barrier | - | | - | | - | | 2 | 25 |
| 3. pot. well | - | | - | | - | | 2 | 40 |
| 4. pot. barrier | - | | - | | - | | 6 | 25 |

For all the film aggregates the U-I-characteristics were measured and for these pronounced current maximums were obtained, whereby for the narrower potential barriers stronger current intensities were obtained. As compared to the film aggregates a to c, approximately a ten-fold current maximum was distinctly obtained for the film agregate d, the intensifying factor being the increase in the number of potential wells.

## Claims

1. A film aggregate which comprises at least three monomolecular layers (2) provided on a conductive substrate (1) and prepared from a surface active organic compound of liquid crystal type using techniques such as for example Langmuir-Blodgett film-forming techniques, characterised in that the film layers form an uneven number and make up at least three zones (A,B,C) which are parallel to the substrate surface, each zone (A,B,C) comprising at least one monomolecular film layer (2), the or each film layer in alternate zones (A,C) including the zone next to the substrate having been formed at a surface pressure which is lower than that used for making the film layers in the or each intermediate zone (B).

2. A film aggregate according to claim 1, which comprises a total of from 1 to 3 zones (B) prepared at a higher surface pressure.

3. A film aggregate according to claim 2, which comprises one zone (B) prepared at a higher surface pressure.

4. A film aggregate according to any one of the preceding claims, in which each zone (A,B,C) comprises from 2 to 7 monomolecular film layers (2).

5. A film aggregate according to any one of the preceding claims, in which the film-forming organic compound is a fatty acid, fatty alcohol or fatty amide, or a glycerol or threitol derivative esterified, etherified or amidated with such a compound, the length of their substantially aliphatic hydrocarbon chains being approximately 8 to approximately 40 carbon atoms.

6. A film aggregate according to claim 5, in which the fatty acid is arachidic acid.

7. A method for the preparation of a film aggregate comprising at least three monomolecular layers (2) provided on a conductive substrate (1) and prepared from a surface active organic compound of liquid crystal type using techniques such as for example Langmuir-Blodgett film-forming techniques, the film layers (2) forming an odd number and making up at least three zones (A,B,C) parallel to the substrate surface each zone comprising at least one film layer (2) wherein the or each film layer in alternate zones (A,C) including the zone next to the substrate is made using a surface pressure which is lower than that used for making the films in the or each intermediate zone.

8. A method according to claim 7, in which the difference between the surface pressures is at least approximately 15 mN/m.

2

C

B

A

1

## FIG.1a

E

BS

25mN/m

40mN/m

$E_F$

$E_F$

0    A    3    B    6    C    9    NUMBER OF
LAYERS

## FIG.1b

25mN/m

40mN/m

NUMBER OF
LAYERS

*FIG. 2a*

$\times 10^{-6} A$

500  I

375

250

125

0

.16      .32      .48      .64      .8

U (V)

*FIG. 2b*

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | WO-A1-87/00343 (KSV-CHEMICALS OY) --- | 1-8 | H 01 L 29/28 B 01 D 1/36 C 09 K 19/00 |
| A | WO-A1-87/00347 (SECR. OF STATE DEFENCE IN HER BRITANNIC MAJESTY'S GOVERNEMENT OF THE UNITED KINGDOM OF GREAT BRITAIN AND NORTHERN IRELAND) --- | 1-8 | |
| A | WO-A1-83/03165 (NAT RESEARCH DE-VELOPMENT CORP) --- | 1-8 | |
| A | GB-A-1 572 181 (IMPERIAL CHEM. IND. LTD) --- | 1-8 | |
| A | US-A-4 554 076 (LM SPEAKTER) --- | 1-8 | **TECHNICAL FIELDS SEARCHED (Int. Cl.4)** B 05 D H 01 B H 01 L C 08 J C 09 K C 23 C |
| A | US-A-4 627 029 (E G WILSON et al) --- | 1-8 | |
| A,T | US-A-4 670 860 (E G WILSON) ----- | 1-8 | |

The present search report has been drawn up for all claims

| Place of search | Date of completion of the search | Examiner |
|---|---|---|
| STOCKHOLM | 17-09-1987 | FORSLUND N |